# EUROPEAN PATENT APPLICATION

(11) **EP 2 299 480 A2**
(43) Date of publication of application: **23.03.2011**
(21) Application number: 10006436.9
(22) Date of filing: 21.06.2010
(51) Int. Cl.: H01L 21/336, H01L 29/78

(54) **A thin body mosfet with conducting surface channel extensions and gate-controlled channel sidewalls**

(30) Priority: 18.09.2009 US 562790
(71) Applicant: Taiwan Semiconductor Manufacturing Company, Ltd., Hsin-Chu, 300-77 (TW)
(72) Inventor: Passlack, Matthias, 3060 Bertem (BE)
(74) Representative: TER MEER - STEINMEISTER & PARTNER GbR

(57) **Abstract**

A thin body MOSFET with conducting surface channel extensions and gate-controlled channel sidewalls is described. One embodiment is a MOSFET comprising a semiconductor substrate; a channel layer disposed on a top surface of the substrate; a gate dielectric layer interposed between a gate electrode and the channel layer; and dielectric extension layers disposed on top of the channel layer and interposed between the gate electrode and Ohmic contacts. The gate dielectric layer comprises a first material, the first material forming an interface of low defectivity with the channel layer. In contrast, the dielectric extensions comprise a second material different than the first material, the second material forming a conducting surface channel with the channel layer.

## Description

### BACKGROUND

This disclosure relates to MOSFETs having channel layers comprising group III-V semiconductors, such as InGaAs, InAs, or InAsSb (hereinafter "III-V MOSFETs" or "thin body MOSFETs"). Prior art III-V MOSFETs typically use InGaAs channels having a low indium mole fraction (< 30%) when fabricated on GaAs substrate and InGaAs channels having a higher indium mole fraction (≈50-100%) when fabricated on InP substrate. III-V MOSFETs with higher In content channel layers are also of interest for future CMOS applications on silicon substrate.

Prior art MOSFETs having a high In mole fraction channel use conventional ion implantation to form source and drain extensions and to reduce parasitic resistance, such as described in Y. Xuan et al., "High-Performance Inversion-Type Enhancement-Mode InGaAs MOSFET with Maximum Drain Current Exceeding 1 A/mm," Electron Device letters, Vol. 29, No. 4, p. 294 (2008). The resulting effective parasitic series source/drain resistance (R_{sd}) is about 2000 Ω µm and subthreshold swing (S) is 200 mV/dec for a 0.5 µm device. The prior art further describes an implant free III-V MOSFET that employs a charge layer having a polarity opposite that of the channel and formed on the surface of the gate oxide thereby to reduce parasitic resistance in the source/drain extensions, such as described in R. J. W. Hill et al., "1 µm gate length, In0.75Ga0.25As channel, thin body n-MOSFET on InP substrate with transconductance of 73 µS/µm," Electronics Letter, Vol. 44, No. 7, pp. 498-500 (2008), and U.S. Patent Publication No. 2008/0102607. In this case, R_{sd} is about 530 Ω µm and subthreshold swing is 1100 mV/dec for a 1 µm device. The prior art also discloses the use of a single oxide layer that extends from the source contact to the drain contact, inducing a conducting surface channel simultaneously underneath the gate and in the source/drain extensions, as described in N. Li et al., "Properties of InAs metal-oxide-semiconductor structures with atomic-layer-deposited Al2O3 Dielectric," Applied Physics Letters, Vol. 92, 143507 (2008). For a 5 µm device, an R_{sd} of 52,500 Ω µm and a subthreshold swing of 400 mV/dec were measured. The measured transconductance (gₘ) is very small with 2.3 µS/µm.

The International Technology Roadmap for Semiconductors requires R_{sd} ≤ 155Ω µm, S<100 mV/dec, and gₘ=3000-4000 pS/pm for CMOS generations of 22 nm and below. All prior art technologies are unable to meet those requirements.

### SUMMARY

One embodiment is a MOSFET comprising a semiconductor substrate; a channel layer disposed on a top surface of the substrate; a gate dielectric layer interposed between a gate electrode and the channel layer; and dielectric extension layers disposed on top of the channel layer and interposed between the gate electrode and Ohmic contacts. The gate dielectric layer comprises a first material, the first material forming an interface of low defectivity with the channel layer. In contrast, the dielectric extension layers comprise a second material different than the first material, the second material forming a conducting surface channel with the channel layer.

### BRIEF DESCRIPTION OF THE DRAWINGS

Figs. 1A-1C are views of various prior art III-V MOSFETs.

Fig. 2 is a cross-sectional view perpendicular to the gate of a III-V MOSFET including conducting surface channel extensions and gate-controlled channel sidewalls in accordance with one embodiment.

Fig. 3 is a cross-sectional view under and parallel to the gate of the MOSFET of Fig. 2.

Fig. 4 is a top plan view of the MOSFET of Fig. 2.

### DETAILED DESCRIPTION

Aspects of the present disclosure are best understood from the following detailed description when read with the accompanying figures. It is emphasized that, in accordance with the standard practice in the industry, various features are not drawn to scale. In fact, the dimensions of the various features may be arbitrarily increased or reduced for clarity of discussion.

The embodiments described herein provide a III-V MOSFET having low parasitic onresistance (R_{sd}) and high transconductance (gₘ) in an on state, and low subthreshold swing (S) in off-state. One embodiment comprises a III-V MOSFET having simultaneously low onresistance due to an induced conducting surface channel in the source/drain extensions only, high transconductance due to use of a gate oxide with low interfacial defectivity in the gate area, and low subthreshold swing due to depleted channel sidewalls in the off-state of the device.

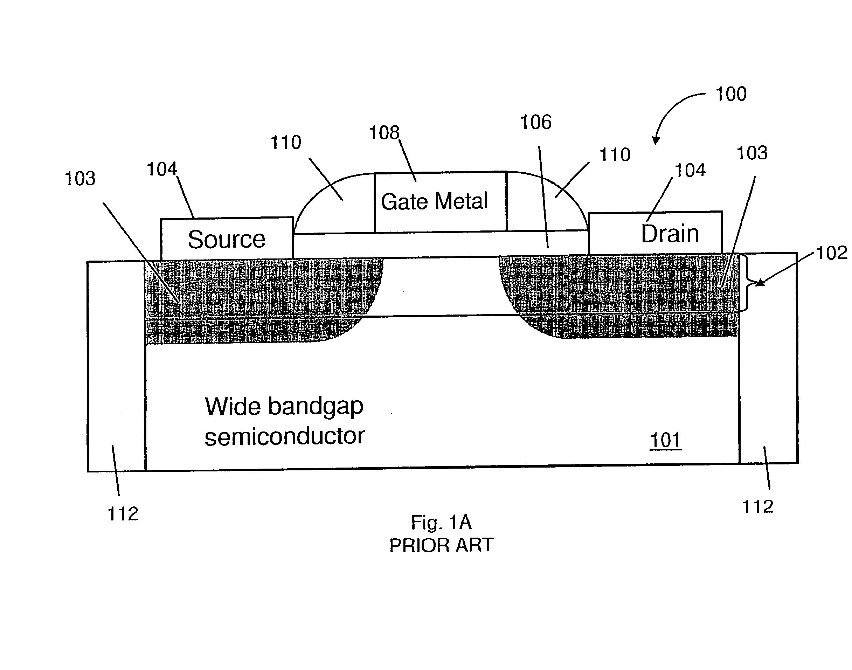

Figs. 1A-1C illustrate views of various prior art III-V MOSFETs. Fig. 1A illustrates a cross-sectional view of a first prior art III**-**V MOSFET 100 comprising a wide bandgap semiconductor substrate layer 101 on which is disposed a channel layer 102 and having ion-implanted extensions 103 on parts of which are disposed Ohmic contacts 104. The channel layer 102 comprises one of a plurality of group III-V semiconductors, such as, for example, InGaAs, InAs, or InAsSb.

A gate oxide layer 106 extends between the Ohmic contacts 104, and a gate electrode 108 and gate sidewalls 110 are disposed atop the gate oxide layer. The MOSFET 100 further includes an isolation region 112. Activation efficiencies of donor implants in compound semiconductors are low, typically of the order of a few percent, and active donor concentrations are limited to approximately 5x10¹⁸ cm⁻³. For example, for a 10 nm channel layer of mobility of 2500 cm²/Vs, sheet resistivity is high with 500 Ω/sq, resulting in excessively high R_{sd}.

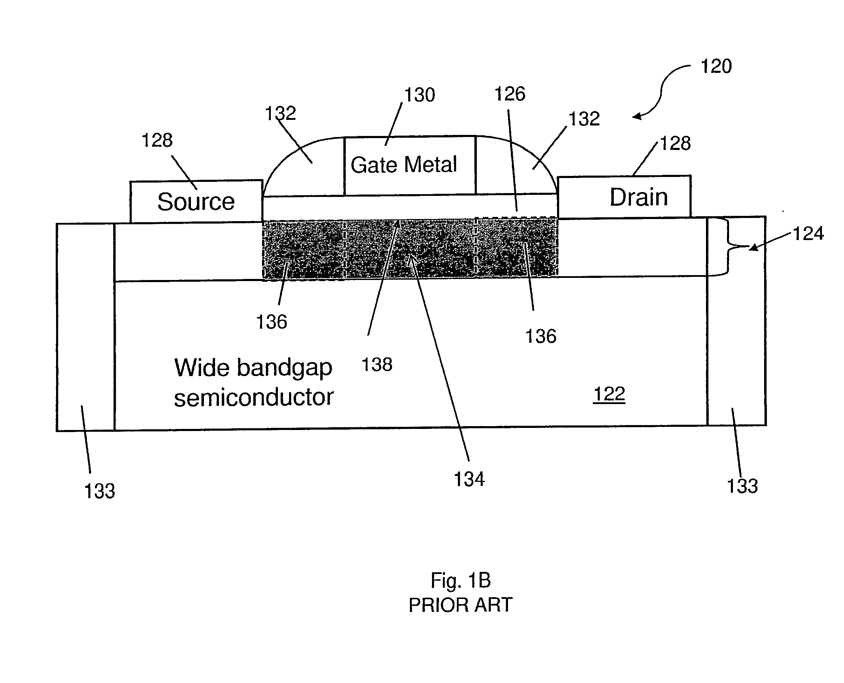

Fig 1B illustrates a cross-sectional view of a second prior art III-V MOSFET 120 comprising a wide bandgap semiconductor substrate layer 122 on which is disposed a channel layer 124. The channel layer 124 comprises one of a plurality of group III-V semiconductors, such as, for example, InGaAs, InAs, or InAsSb.

The MOSFET 120 includes a single gate oxide layer 126 extending between source and drain Ohmic contacts 128. A gate electrode 130 and gate sidewalls 132 are disposed atop the gate oxide layer 126. The MOSFET 120 further includes an isolation region 133. High In mole fraction InGaAs, and in particular InAs channel layers, result in a conducting surface channel 134 when the surface thereof is oxidized or otherwise terminated with a high level of defectivity. Although low resistance can potentially be achieved in extensions 136 situated between the gate electrode 130 and Ohmic contacts 128, charge control under the gate electrode 130 is virtually impossible due to high defectivity at an interface 138 between the gate oxide layer 126 and the channel layer 124, resulting in very small transconductance.

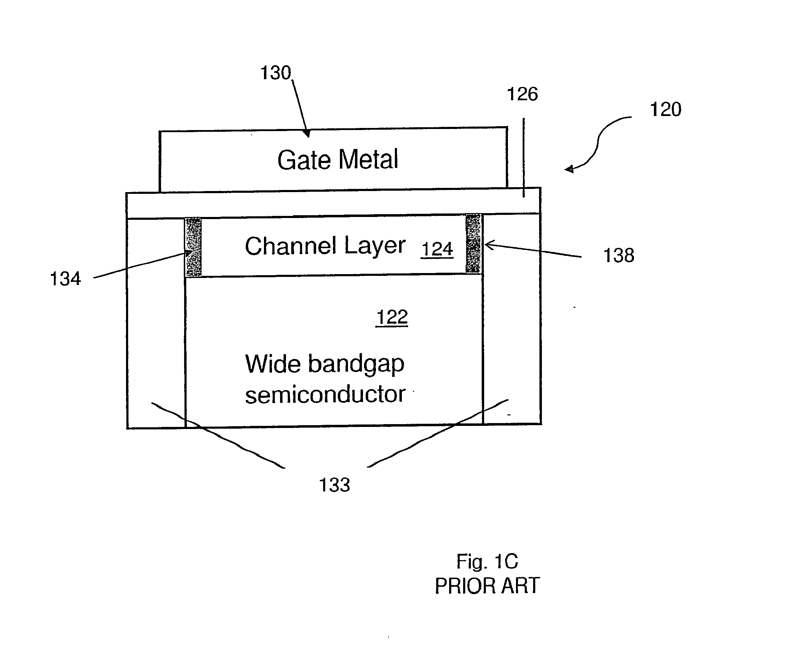

Figs. 1A and 1B depict cross-sectional views perpendicular to the respective gate electrodes of the MOSFETs depicted therein. Fig. 1C illustrates a cross-sectional view of the MOSFET 120 under and parallel to the gate electrode 130. As shown in Fig. 1C, a high defectivity interface 138 is formed between the isolation region 133 and sidewalls of the channel layer 124, creating a conducting surface channel 134 on the channel layer sidewalls. The layer 134 is a conducting layer that cannot be depleted, resulting in high subthreshold swing and high source-to-drain leakage current in an off-state of the MOSFET 120.

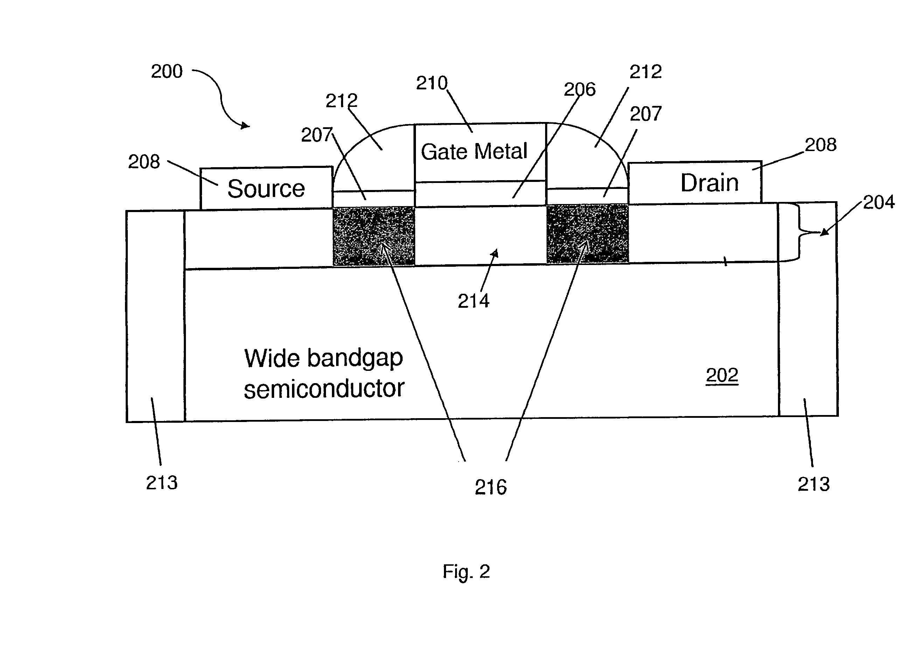

Fig. 2 depicts a cross-sectional view perpendicular to a gate of a III-V MOSFET 200 of one embodiment. As shown in Fig. 2, the MOSFET 200 includes a wide bandgap semiconductor substrate 202 on which is disposed a channel layer 204. The channel layer 204 comprises one of a plurality of group III-V semiconductors, such as, for example, InGaAs, InAs, or InAsSb.

The MOSFET 200 includes a gate dielectric 206 and extension dielectric 207 extending between source and drain Ohmic contacts 208. A gate electrode 210 is disposed atop the gate dielectric 206 and gate sidewalls 212 are disposed atop the extension dielectric 207. The MOSFET 200 further includes an isolation region 213. As previously noted, the gate dielectric 206 comprises a suitable oxide or other insulating material providing an interface of low defectivity with the channel layer 204, resulting in an area of efficient charge control under the gate electrode 210, designated by a reference numeral 214. In particular, the area 214 is gate-controlled and can be efficiently depleted of charge carriers in the off-state of the device 200.

The extension dielectric 207 is disposed adjacent to and is self-aligned with the gate electrode 210 to induce a surface conducting channel 216, which minimizes extension resistance. The extension dielectric 207 comprises a suitable oxide or other insulating material that creates a high defectivity interface with the channel layer 204, thus creating a charge accumulation layer at or in the vicinity of the semiconductor surface. The extension dielectric 207 can be relatively easily fabricated by, for example, oxidization of the surface of the channel layer 204.

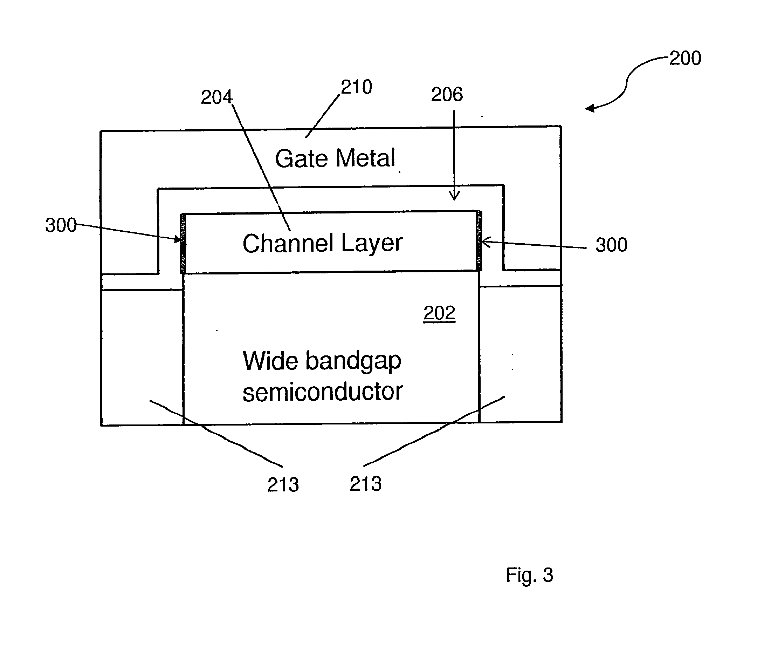

Fig. 3 illustrates a cross-sectional view of the MOSFET 200 under and parallel to the gate electrode 210. Sidewalls 300 of the channel layer 204 form an interface of low defectivity with the gate dielectric 206, thus enabling efficient charge control at the sidewalls 300. As a result, area comprising the sidewalls 300, similar to the area 214, is gate-controlled and can be efficiently depleted of charge carriers in the off-state of the device 200.

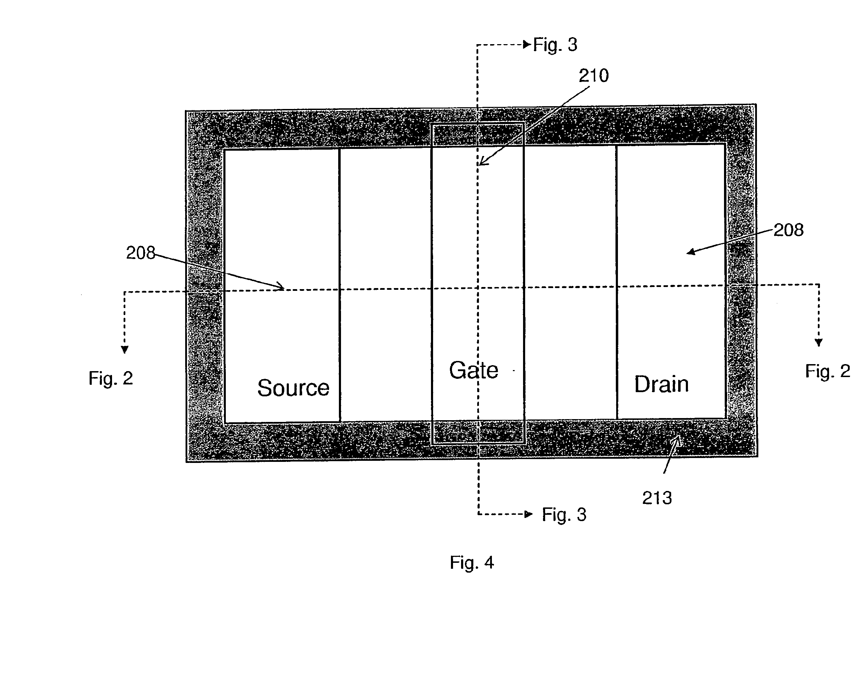

Fig. 4 is a top plan view of the MOSFET 200 showing placement of the isolation region 213 relative to the gate electrode 210 and source and drain Ohmic contacts 208.

While the preceding shows and describes one or more embodiments, it will be understood by those skilled in the art that various changes in form and detail may be made therein without departing from the spirit and scope of the present disclosure. For example, various steps of the described methods may be executed in a different order or executed sequentially, combined, further divided, replaced with alternate steps, or removed entirely. In addition, various functions illustrated in the methods or described elsewhere in the disclosure may be combined to provide additional and/or alternate functions. Therefore, the claims should be interpreted in a broad manner, consistent with the present disclosure.

## Claims

1. A MOSFET comprising:
a semiconductor substrate;
a channel layer disposed on a top surface of the substrate;
a gate dielectric layer interposed between a gate electrode and the channel layer; and
dielectric extension layers disposed on top of the channel layer and interposed between the gate electrode and Ohmic contacts;
wherein the gate dielectric layer comprises a first material, the first material forming an interface of low defectivity with a top surface of the channel layer; and
wherein the dielectric extensions layers comprise a second material different than the first material, the second material forming a conducting surface channel with the channel layer.

2. The MOSFET of claim 1 wherein the channel layer comprises a group III-V semiconductor.

3. The MOSFET of claim 1 or 2 wherein the gate dielectric layer further disposes along front and back sides of the channel layer.

4. The MOSFET of claim 1, 2, or 3 wherein the first material forms the interface of low defectivity with the channel layer along the top surface and front and back surfaces thereof.

5. The MOSFET of claim 1, 2, 3, or 4, wherein the channel layer comprises one of InGaAs, InAs, and InAsSb.

6. The MOSFET of claim 1, 2, 3, 4, or 5, wherein the substrate comprises a wide bandgap semiconductor material.

7. The MOSFET of claim 1, 2, 3, 4, 5 or 6, wherein the dielectric extension is fabricated by oxidizing a surface of the semiconductor substrate.

8. The MOSFET of claim 1, 2, 3, 4, 5, 6, or 7, wherein the gate dielectric comprises an oxide.

9. The MOSFET of claim 1, 2, 3, 4, 5, 6, 7 or 8, further comprising an isolation region along an edge of the semiconductor substrate.

10. A method of fabricating a thin-body MOSFET comprising a gate electrode disposed between source and drain Ohmic contacts, the method comprising:
providing a channel layer on a top surface of a semiconductor substrate;
providing a gate dielectric layer between the gate electrode and the channel layer; and
providing dielectric extension layers disposed on top of the channel layer and interposed between the gate electrode and Ohmic contacts;
wherein the gate dielectric layer comprises a first material, the first material forming an interface of low defectivity with the channel layer; and
wherein the dielectric extensions comprise a second material different than the first material, the second material forming a conducting surface channel with the channel layer.

11. The method of claim 10 wherein the channel layer comprises one of InGaAs, InAs, and InAsSb.

12. The method of claim 10or 11 wherein the dielectric extension is fabricated by oxidizing a surface of the channel layer.
